# FASCICULE DE BREVET EUROPEEN

(11) **EP 0 831 589 B1**
(45) Date de publication et mention de la délivrance du brevet: **19.01.2000**
(21) Numéro de dépôt: 97460036.3
(22) Date de dépôt: 11.09.1997
(51) Int. Cl.: H03K 17/22

(54) **Circuit électronique pourvu d'un dispositif de neutralisation**
Elektronische Schaltung versehen mit Neutralisierungseinrichtung
Electronic circuit provided with a device for neutralisation

(30) Priorité: 19.09.1996 FR 9611636
(43) Date de publication de la demande: 25.03.1998
(73) Titulaire: STMicroelectronics S.A., 94250 Gentilly (FR)
(72) Inventeur: Malherbe, Alexandre, Cabinet Ballot-Schmit, 56100 Lorient (FR)
(74) Mandataire: Schmit, Christian Norbert Marie

(56) Documents cités:
- EP-A- 0 665 648
- DE-A- 3 515 611
- US-A- 5 477 176

## Description

La présente invention concerne la neutralisation d'un circuit électronique lorsque ce dernier est insuffisamment alimenté. L'invention est conçue tout particulièrement pour des circuits alimentés par de faibles tensions d'alimentation. Elle trouve son application notamment dans le domaine de la téléphonie mobile, des circuits "contactless" et des micro-ordinateurs portables.

Lors de l'établissement de la tension d'alimentation dans un circuit électronique, les fonctions du circuit sont généralement neutralisées et rendues inopérantes car on ne pourrait autrement garantir leur résultat. Il en est de même lors d'une chute importante de la tension d'alimentation ou de sa coupure.

Pour ce faire, des dispositifs ont été développés pour neutraliser le fonctionnement du circuit électronique pour des valeurs de tension d'alimentation inférieures à une valeur seuil. Cette valeur seuil est généralement déterminée en fonction de la valeur de la tension d'alimentation et du circuit électronique à neutraliser.

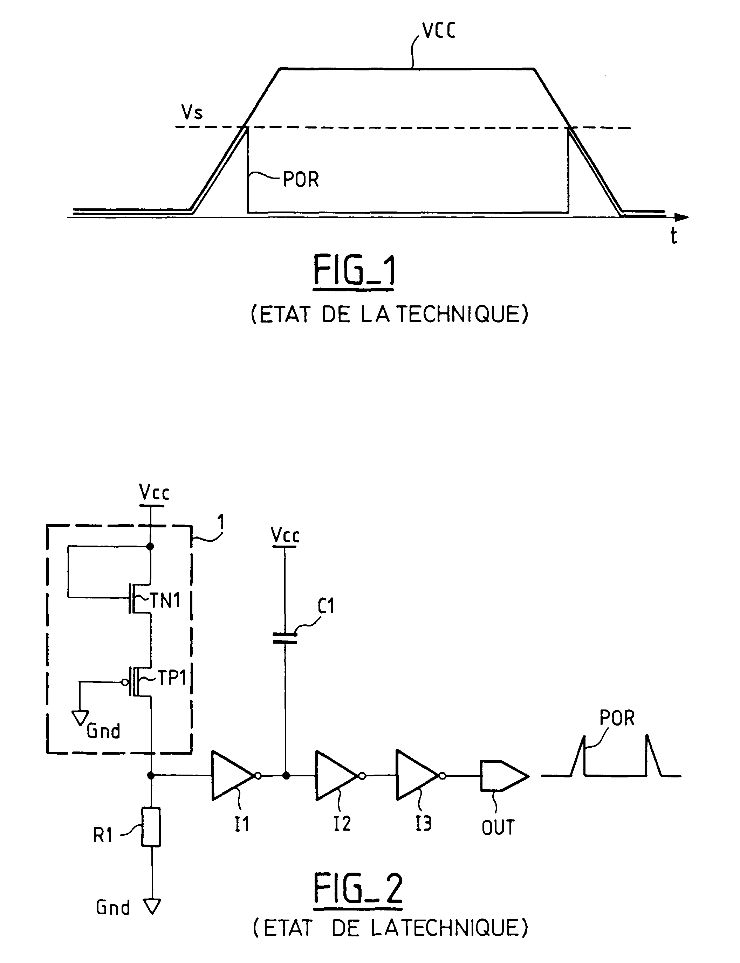

Les dispositifs de neutralisation connus comprennent de manière classique un circuit de commande et un moyen inhibiteur du fonctionnement du circuit électronique. Le circuit de commande délivre un signal de commande qui conditionne la sortie du moyen inhibiteur. L'allure du signal de commande est représentée sur la figure 1. La courbe du signal de commande POR (Power On Reset) se superpose à celle de la tension d'alimentation VCC tant que cette dernière reste inférieure à une valeur seuil Vs. Au delà, la valeur de tension du signal de commande POR devient nulle.

Le moyen inhibiteur transforme ensuite le signal de commande en un signal binaire. Lorsque la tension du signal de commande POR est nulle, le signal binaire présente un niveau logique haut. Pour toute autre valeur du signal de commande, le signal binaire issu du moyen inhibiteur est à un niveau bas. Ainsi, pour toute valeur de tension d'alimentation supérieure à la tension seuil Vs, c'est-à-dire lorsque le signal binaire présente un niveau haut, le fonctionnement du circuit électronique situé en aval du moyen inhibiteur est autorisé.

Le moyen inhibiteur peut être par exemple une bascule dont l'entrée de "remise à zéro" reçoit le signal de commande POR et l'entrée de "mise à un" un signal de mise en marche du circuit électronique. Le signal binaire issu du moyen inhibiteur neutralise alors les fonctionnalités du circuit électronique placé en aval du moyen inhibiteur lorsque le signal binaire délivré par ce dernier présente un niveau bas.

Le circuit de commande est l'élément clé du dispositif de neutralisation. La figure 2 représente un circuit de commande connu réalisé pour des circuits alimentés par une tension de 3 volts. Il comporte un premier moyen 1 pour fixer la valeur seuil, relié par une entrée à une borne d'alimentation Vcc et par sa sortie à une borne de masse Gnd par l'intermédiaire d'une résistance R1. Ce moyen 1 devient passant lorsque la tension d'alimentation devient supérieure à une tension seuil propre, qui est égale à la valeur seuil Vs.

Dans l'exemple de la figure 2, le moyen 1 est constitué d'un transistor TN1 de type N dont la grille et le drain sont reliés à la borne d'alimentation Vcc et la source est reliée à la source d'un transistor natif de type P TP1. Le drain du transistor TP1 est relié à la résistance R1 et sa grille est connectée à la borne de masse Gnd. On rappelle qu'un transistor natif est un transistor n'ayant pas reçu d'implantation complémentaire dans son canal de conduction. Sa tension de seuil de conduction est supérieure en valeur absolue à celle d'un transistor enrichi de type P. Dans notre exemple, cette tension est de l'ordre de 1,3 volts en valeur absolue.

Le circuit de commande comporte en outre un inverseur Il connecté entre la sortie du moyen 1 et une borne de sortie OUT par laquelle est délivré le signal de commande. Un condensateur de démarrage C1 est connecté entre la borne d'alimentation Vcc et la borne de sortie OUT pour obtenir le niveau de sortie attendu pendant le début de la montée de la tension d'alimentation.

Dans cet exemple, la tension seuil propre du moyen 1 qui représente la valeur seuil Vs est égale à la somme des valeurs des seuils de conduction des transistors TN1 et TP1. En pratique, elle est légèrement supérieure à cette valeur car il faut une différence de potentiel suffisante aux bornes de la résistance R1 pour faire basculer l'inverseur I1.

Par ailleurs, deux inverseurs I2 et I3 sont montés en cascade entre la sortie de l'inverseur I1 et la borne de sortie OUT. Ces deux inverseurs permettent de regénérer les signaux présents à la sortie de l'inverseur I1. En sortie du circuit de commande, on obtient alors deux niveaux possibles: un niveau haut et un niveau bas.

De préférence, les plages de commutation des inverseurs I2 et I3 sont décalées afin d'augmenter la stabilité de ces deux niveaux.

Le fonctionnement d'un tel circuit de commande est bien connu de l'homme du métier. Sommairement, tant que la valeur de la tension d'alimentation Vcc est inférieure à la somme des seuils de conduction des transistors TN1 et TP1, la valeur de la tension à l'entrée de l'inverseur I1 est nulle. La borne de sortie OUT du dispositif délivre alors une tension égale à la tension d'alimentation. Dès que les deux transistors TN1 et TP1 deviennent conducteurs, la borne de sortie OUT délivre une tension nulle.

Pour que le dispositif de neutralisation fonctionne de manière satisfaisante, il existe des conditions sur la tension de seuil Vs. Ces conditions sont prises en compte au moment de la réalisation du circuit de commande. En effet, la spécification du circuit électronique impose habituellement une plage de tolérance pour la valeur de la tension d'alimentation. Cette plage de tolérance est fixée par le client. En règle générale, elle est de +/- 10% par rapport à la valeur nominale de tension d'alimentation. La valeur de la tension d'alimentation est donc comprise entre une valeur minimale Vccₘᵢₙ et une valeur maximale Vccₘₐₓ.

Par ailleurs, la valeur seuil Vs possède également une plage d'incertitude. En effet, elle est détectée par un circuit de commande réalisé à partir de composants dont les paramètres peuvent varier avec le procédé de fabrication et la température. Donc la valeur seuil Vs varie également entre une valeur minimale Vsₘᵢₙ et une valeur maximale Vsₘₐₓ.

Une première condition pour que le dispositif de neutralisation fonctionne correctement est la suivante: Vsₘₐₓ < Vccₘᵢₙ. En effet, dans le cas où Vcc = Vccₘᵢₙ et Vs = Vsₘₐₓ, il faut obligatoirement que Vs soit inférieur à Vcc sinon la tension de seuil Vs ne sera jamais atteinte par le circuit de commande et le dispositif de neutralisation inhibera en permanence le fonctionnement du circuit électronique.

Cette première condition pose un problème dans le cas où la valeur de la tension d'alimentation est faible. En effet, la largeur de la plage d'incertitude de la valeur seuil Vs n'est pas seulement fonction de la valeur de la tension d'alimentation Vcc, elle dépend également des paramètres de fabrication et de la température. Bien que la largeur de la plage de tolérance de la tension d'alimentation diminue à mesure que sa valeur nominale diminue, la largeur de la plage de la valeur seuil reste quasi-identique. La condition précédente devient de plus en plus difficile à remplir.

Par ailleurs, il faut également considérer le fait que les composants ou groupes de composants du circuit électronique à neutraliser ont une limite fonctionnelle Vf en deçà de laquelle ils ne remplissent plus leur rôle. En effet, si on considère par exemple un chemin de courant du circuit électronique comportant deux diodes montées en série, il est nécessaire que la tension de seuil Vs soit supérieure à la somme des tensions de seuil de conduction des deux diodes pour qu'elles soient passantes et remplissent leur rôle de conduction. Par conséquent, il faut Vsₘᵢₙ > Vfₘₐₓ où Vfₘₐₓ est la limite fonctionnelle maximale des chemins du circuit.

Pour les circuits électroniques alimentés par des tensions supérieures ou égales à 3 volts, l'écart de tension entre la valeur de tension d'alimentation Vccmin et la limite fonctionnelle maximale Vfₘₐₓ imposée par le circuit électronique, est généralement suffisamment important pour que la tension seuil Vs et sa plage d'incertitude s'intercale entre ces deux valeurs limites.

Pour des circuits alimentés par de faibles tensions, de l'ordre de 1,8 volts, cet écart est parfois trop restreint pour que la tension seuil Vs respecte les deux conditions.

La solution la plus évidente consisterait à diminuer la taille de la plage d'incertitude de la tension seuil Vs. Pour cela, il faudrait avoir recours à des circuits plus complexes et onéreux, ou améliorer les performances du procédé de fabrication, ce qui n'est pas toujours possible et représenterait un lourd investissement.

La solution adoptée par l'invention consiste à réaliser un dispositif de neutralisation permettant de modifier la condition portant sur la limite fonctionnelle Vf.

Le circuit électronique à neutraliser se divise en portions de circuit regroupant sur un même chemin de courant un ou plusieurs composants. Généralement, un de ces chemins est dit critique car il nécessite une tension d'alimentation minimale Vf supérieure aux autres pour le bon fonctionnement de la portion de circuit s'y rapportant. Cette valeur de la tension d'alimentation définit la valeur de la limite fonctionnelle Vf du circuit.

On connaît un dispositif de neutralisation, décrit dans le document US 5 477 176, comportant un moyen inhibiteur pour bloquer le fonctionnement d'un circuit électronique et un circuit de commande reproduisant un chemin critique du circuit électronique à neutraliser et n'autorisant le fonctionnement de ce circuit que lorsque ledit chemin critique est passant.

Cependant, pour une même structure de circuit, il peut y avoir parfois plusieurs chemins critiques potentiels en raison de la variation de paramètres inhérents au procédé de fabrication et à la température de fonctionnement du circuit.

Si on ne reproduit qu'un seul chemin critique, comme dans le document US 5 477 176, la tension de seuil de ce chemin doit être supérieure à la valeur de limite fonctionnelle maximale obtenue avec les conditions de température et de procédé les plus défavorables, c'est-à-dire Vsₘᵢₙ > max(Vfₘₐₓ), ce qui restreint encore le choix pour la tension Vs sachant que Vs doit aussi respecter la condition Vsₘₐₓ<Vccₘᵢₙ.

Dans le circuit de commande de l'invention, l'ensemble des chemins critiques potentiels du circuit électronique sont reproduits et arrangés de manière à mettre en évidence une tension de seuil Vs qui sera égale à la valeur de la limite maximale Vfₘₐₓ du circuit électronique pour des conditions de température et de procédé données. La condition Vsmin>Vfmax ne sera plus à satisfaire puisque Vs≈Vfₘₐₓ. En pratique, ce dispositif de neutralisation et le circuit électronique sont réalisés sur la même puce et sont soumis aux mêmes conditions de température et de procédé.

Aussi l'invention a pour objet un ensemble comprenant un circuit électronique fonctionnel et un dispositif de neutralisation destiné à bloquer le fonctionnement dudit circuit électronique fonctionnel lorsque la tension d'alimentation est insuffisante pour en assurer le fonctionnement correct,
le circuit électronique fonctionnel présentant une pluralité de chemins critiques potentiels entre une borne d'alimentation et une borne de masse, un chemin étant critique lorsque la valeur de la tension d'alimentation nécessaire pour assurer le fonctionnement correct de son composant ou groupe de composants est suffisante pour assurer le fonctionnement correct de l'ensemble,
le dispositif de neutralisation comprenant, en amont d'un moyen inhibiteur pour bloquer le fonctionnement du circuit électronique, un circuit de commande reproduisant les chemins critiques potentiels du circuit électronique fonctionnel sous forme de circuits élémentaires, chacun connecté entre la borne d'alimentation et la borne de masse et délivrant un signal élémentaire indiquant par son état si la tension d'alimentation est suffisante pour assurer son fonctionnement correct, le moyen inhibiteur n'étant désactivé que lorsque la totalité des circuits élémentaires délivrent des signaux élémentaires de même état indiquant que la tension d'alimentation est suffisante pour assurer leur fonctionnement correct.

Afin de tenir compte de l'ensemble des signaux en provenance des circuits élémentaires, le circuit de commande du dispositif de neutralisation comporte une porte logique recevant sur chacune de ces entrées un signal élémentaire et délivrant un signal de commande au moyen inhibiteur.

De préférence, les chemins critiques potentiels du circuit électronique sont reproduits dans les circuits élémentaires avec des composants ou groupes de composants faiblement résistifs pour que la conduction des composants soit franche dès le début de leur mise en conduction.

Pour ce faire, on prévoit pour la réalisation du circuit de neutralisation l'utilisation de transistors ayant un rapport W/L très supérieur à 1.

Par ailleurs, le circuit de commande du dispositif de neutralisation peut comporter en outre un circuit élémentaire supplémentaire produisant un signal élémentaire qui change d'état pour une valeur fixée de la tension d'alimentation, déterminée de telle façon qu'elle soit une valeur seuil minimale de la tension d'alimentation pouvant assurer la désactivation du moyen inhibiteur. Ce circuit supplémentaire permet de limiter l'intervalle de variation de la tension seuil Vs de l'ensemble, c'est-à-dire de la tension d'alimentation nécessaire pour assurer un fonctionnement correct de l'ensemble. Ce circuit supplémentaire est par exemple un détecteur de tension stable en température.

L'invention sera mieux comprise à la lecture de la description qui suit et à l'examen des figures qui l'accompagnent. Celles-ci ne sont données qu'à titre indicatif et nullement limitatif de l'invention. Les figurent montrent :
- figure 1 : un diagramme temporel d'un signal de commande issu d'un circuit de commande;
- figure 2 : une représentation schématique d'un circuit de commande d'un dispositif de neutralisation connu;
- figure 3 : un schéma fonctionnel d'un circuit de commande d'un dispositif de neutralisation selon l'invention;
- figure 4 : un exemple de réalisation d'un circuit de commande d'un dispositif de neutralisation selon l'invention;
- figure 5 : une représentation schématique d'un détecteur de tension stable en température d'un dispositif de neutralisation selon l'invention;

Les figures 1 et 2 faisant partie de l'état de la technique ont été préalablement décrites dans le préambule de la description.

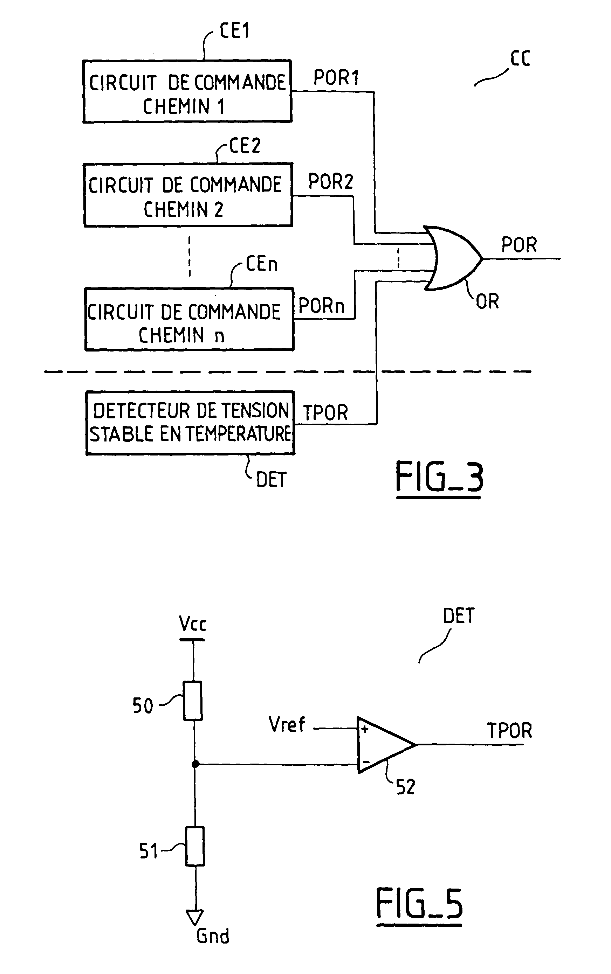

La figure 3 est un schéma fonctionnel d'un circuit de commande CC d'un circuit de neutralisation selon l'invention.

Ce circuit de commande CC comprend tout d'abord n circuits élémentaires CE1...CEn, chacun étant représentatif d'un chemin critique du circuit électronique. Bien entendu, dans le cas d'un circuit électronique très simple, ce dernier pourra ne comporter qu'un seul chemin critique. Le contenu des circuits élémentaires est donc fonction de la structure du circuit électronique à neutraliser en ce qu'ils reprennent des portions de ce circuit. De façon évidente, la tension seuil Vs des circuits élémentaires satisfait la première condition énoncée précédemment.

Chaque circuit élémentaire CE1...CEn délivre un signal élémentaire de commande POR1...PORn. L'allure des signaux élémentaires est équivalente à celle du signal POR de la figure 1. Une porte logique OR reçoit sur chacune de ces entrées un signal élémentaire de commande POR1...PORn et délivre un signal de commande commun POR prévu pour commander un moyen inhibiteur (non représenté) placé en aval du circuit de commande CC. La porte logique OR est de type OU car l'ensemble des signaux élémentaires POR1...PORn doivent présenter un niveau logique bas pour désactiver le moyen inhibiteur.

Un détecteur de tension stable en température DET est également prévu dans le circuit de commande CC. Il délivre un signal élémentaire de commande TPOR stable en température sur une entrée supplémentaire de la porte OR. Le signal TPOR est utilisé pour limiter l'intervalle de variation de la tension seuil Vs du signal de commande POR. La valeur du signal de tension TPOR est prise de préférence égale à la valeur moyenne de la tension seuil Vs. Ainsi, si pour des conditions de procédé et de température données , les circuits élémentaires conduisent à obtenir une faible valeur seuil Vs, le signal de tension TPOR permettra d'augmenter la valeur de la tension seuil Vs du signal de commande POR. Le détecteur de tension stable en température DET sera décrit dans la partie de la description se rapportant à la figure 5.

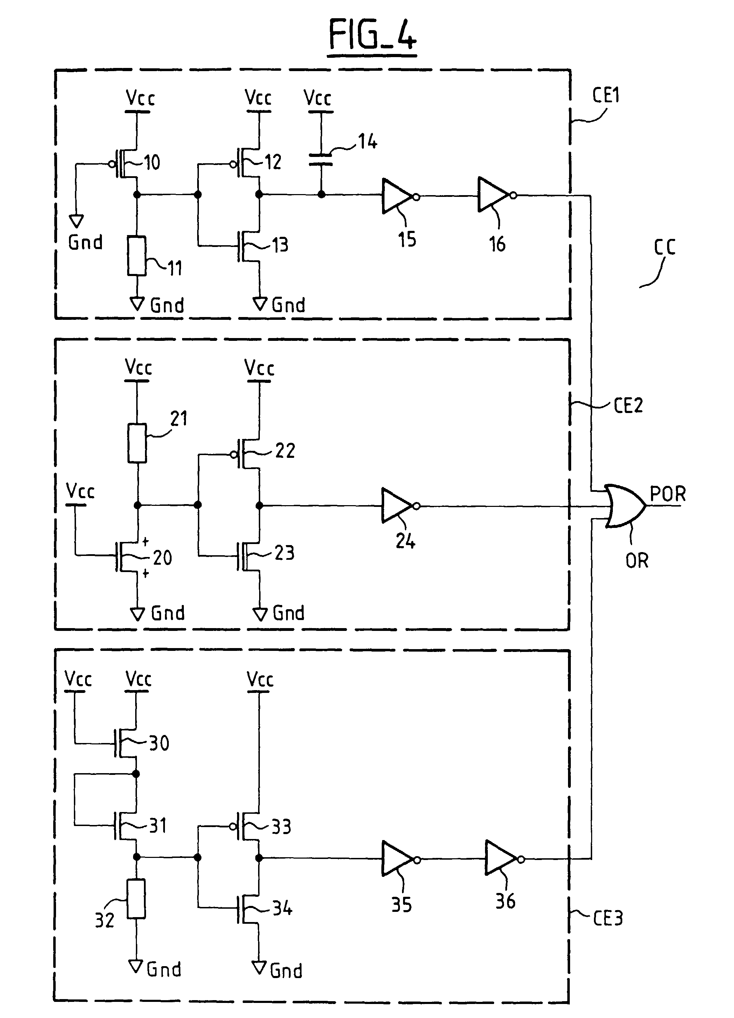

Un exemple de circuit de commande selon l'invention est décrit à la figure 4. Dans cet exemple, le circuit électronique placé en aval de ce circuit de commande comporte trois chemins critiques sur l'intervalle de température de la spécification. Par conséquent, le circuit de commande comporte trois circuits élémentaires CE1, CE2, CE3 correspondants.

Le premier circuit élémentaire CE1 permet de détecter la valeur seuil d'un premier chemin critique du circuit électronique comportant un transistor natif de type P. Pour ce faire, le circuit CE1 comporte un transistor natif 10 de type P dont la source est reliée à une borne d'alimentation Vcc, la grille à une borne de masse Gnd. Le drain du transistor natif 10 est par ailleurs relié à la borne de masse Gnd par l'intermédiaire de la résistance de polarisation 11. Cette résistance est dimensionnée de manière à obtenir, par exemple, un courant de polarisation de 1 µA environ. Le drain du transistor natif 10 est également connecté à l'entrée d'un premier inverseur classique constitué des transistors 12 et 13, respectivement de type P et de type N. La sortie de cet inverseur est reliée à une entrée de la porte logique OR de type OU par l'intermédiaire de deux inverseurs 15 et 16. Un condensateur de démarrage 14 est également prévu entre la sortie du premier inverseur et la borne d'alimentation Vcc pour obtenir un "1" logique à la sortie du premier inverseur au début de la montée de la tension de la tension d'alimentation VCC.

Le second circuit élémentaire CE2 permet de détecter la valeur seuil d'un second chemin critique du circuit électronique comportant un transistor haute tension de type N. Un transistor haute tension de type N est un transistor dont l'épaisseur d'oxyde de grille est plus importante que celle d'un transistor traditionnel. A cet effet, le circuit élémentaire CE2 comporte un transistor haute tension 20 dont la grille est reliée à la borne d'alimentation Vcc et la source à la borne de masse Gnd. Le drain de ce transistor est, quant à lui, relié d'une part à la borne d'alimentation Vcc par l'intermédiaire d'une résistance de polarisation 21 et d'autre part à l'entrée d'un inverseur constitué d'un transistor 22 de type P et d'un transistor natif 23 de type N. Enfin la sortie de l'inverseur est connectée sur une deuxième entrée de la porte logique OR par l'intermédiaire d'un second inverseur 24. Le seuil de conduction du transistor natif 23 est très bas, de l'ordre de 0.2 volts. Ainsi, la sortie de l'inverseur constitué des transistors 22 et 23 délivrera un "0" logique dès le début de la rampe de tension d'alimentation.

Enfin, le circuit élémentaire CE3 permet de détecter le seuil de conduction d'un troisième chemin critique du circuit électronique comportant deux transistors de type N montés en série. Le schéma du circuit élémentaire CE3 est identique au schéma du circuit CE1. Le transistor 10 est cependant remplacé par deux transistors 30, 31 de type N montés en série. La grille et le drain du transistor 30 sont reliés à la borne d'alimentation Vcc alors que sa source est reliée au drain et à la grille du transistor 31. Bien entendu, la résistance de polarisation référencée 32, dont l'une des bornes est reliée à la source du transistor 31, est dimensionnée en fonction des transistors 30 et 31. La sortie de ce troisième circuit élémentaire est connectée à une troisième entrée de la porte OR.

Le fonctionnement des circuits élémentaires CE1, CE2 et CE3 est bien connu de l'homme du métier et correspond au fonctionnement du circuit de commande connu de la figure 2.

De préférence, les composants reproduisant les chemins critiques du circuit électronique, c'est-à-dire les transistors 10, 20, 30 et 31, sont réalisés avec une résistance de conduction (rₒₙ) faible pour qu'ils laissent passer franchement le courant dès que leur tension de conduction est atteinte. Pour ce faire, ces transistors sont conçus avec un rapport W/L élevé, très supérieur à 1.

Comme il a été mentionné dans la description de la figure 3, on peut compléter le circuit de commande de l'invention par un détecteur de tension stable en température DET pour limiter l'intervalle de variation de la tension seuil Vs du signal de commande POR. Ce circuit agit lorsque les conditions de température et de procédé de fabrication sont si favorables que tous les circuits éléméntaires autorisent le fonctionnement du ciruit électronique fonctionnel à basse tension d'alimentation. Le signal de sortie d'un tel circuit change d'état pour une valeur déterminée de la tension d'alimentation, qui de préférence sera égale à la valeur moyenne de la tension Vs. La figure 5 décrit un schéma possible d'un détecteur de tension stable en température.

La détecteur DET comporte un pont de résistances 50, 51 connecté entre la borne d'alimentation Vcc et la borne de masse Gnd. Le point milieu du pont de résistances 50, 51 est connecté à la borne d'entrée négative d'un amplificateur différentiel 52. La borne d'entrée positive de cet amplificateur reçoit une tension de référence Vref fournie par un circuit à largeur de bande communément appelé circuit "bandgap". L'amplificateur différentiel 52 délivre sur sa sortie un signal de température stable en température TPOR.

Le fonctionnement du détecteur DET va être expliqué en supposant que le circuit électronique alimenté par une tension de 1,8 volts. On considère par ailleurs que la valeur moyenne de la tension seuil Vs vaut 1,4 volts et que le circuit à largeur de bande est un circuit classique délivrant une tension stable en température de 1,27 volts.

Les valeurs des résistances 50 et 51 sont alors choisies de manière à ce que la tension sur l'entrée négative de l'amplificateur 52 soit égale à 1,27 volts lorsque la valeur de la tension d'alimentation atteint 1,4 volts. Dans cet exemple, la tension au point milieu du pont de résistances est nécessairement indépendante de la température car les résistances 50 et 51 varient dans les mêmes proportions avec la température.

Le signal élémentaire TPOR change d'état lorsque sa valeur dépasse 1,4 volts. La valeur seuil minimale Vsₘᵢₙ devient alors égale à 1,4 volts pour des paramètres de fabrication donnés. Ce circuit supplémentaire permet ainsi de limiter l'intervalle de variation de la tension seuil Vs.

## Revendications

1. Ensemble comprenant un circuit électronique fonctionnel et un dispositif de neutralisation destiné à bloquer le fonctionnement dudit circuit électronique fonctionnel lorsque la tension d'alimentation est insuffisante pour en assurer le fonctionnement correct,
le circuit électronique fonctionnel présentant une pluralité de chemins critiques potentiels entre une borne d'alimentation et une borne de masse, un chemin étant critique lorsque la valeur de la tension d'alimentation nécessaire pour assurer le fonctionnement correct de son composant ou groupe de composants est suffisante pour assurer le fonctionnement correct de l'ensemble,
le dispositif de neutralisation comprenant, en amont d'un moyen inhibiteur (OR) pour bloquer le fonctionnement du circuit électronique, un circuit de commande (CC) reproduisant les chemins critiques potentiels du circuit électronique fonctionnel sous forme de circuits élémentaires (CE1...CEn), chacun connecté entre la borne d'alimentation et la borne de masse et délivrant un signal élémentaire (POR1...PORn) indiquant par son état si la tension d'alimentation est suffisante pour assurer son fonctionnement correct, le moyen inhibiteur n'étant désactivé que lorsque la totalité des circuits élémentaires (CE1...CEn) délivrent des signaux élémentaires de même état indiquant que la tension d'alimentation est suffisante pour assurer leur fonctionnement correct.

2. Ensemble selon la revendication 1 caractérisé en ce que le circuit de commande (CC) du dispositif de neutralisation comporte une porte logique (OR) recevant sur chacune de ces entrées un des signaux élémentaires (POR1...PORn) et délivrant un signal de commande (POR) au moyen inhibiteur.

3. Ensemble selon l'une des revendications 1 ou 2 caractérisé en ce que les chemins critiques potentiels du circuit électronique sont reproduits dans les circuits élémentaires (CE1...CEn) avec des composants ou groupes de composants (10, 20, 30 et 31) faiblement résistifs.

4. Ensemble selon l'une des revendications précédentes caractérisé en ce qu'un des chemins critiques du circuit électronique comporte un transistor natif de type P (10).

5. Ensemble selon l'une des revendications précédentes caractérisé en ce qu'un des chemins critiques du circuit électronique comporte un transistor haute tension de type N (20).

6. Ensemble selon l'une des revendications précédentes caractérisé en ce qu'un des chemins critiques du circuit électronique comporte deux transistors de type N (30,31) montés en série (31) dont l'un est monté en diode.

7. Ensemble selon l'une des revendications précédentes caractérisé en ce que le circuit de commande du dispositif de neutralisation comporte en outre un circuit élémentaire supplémentaire (DET) produisant un signal élémentaire (TPOR) qui change d'état pour une valeur fixée de la tension d'alimentation, déterminée de telle façon qu'elle soit une valeur seuil minimale de la tension d'alimentation pouvant assurer la désactivation du moyen inhibiteur (OR).

8. Ensemble selon la revendication 7 caractérisé en ce que le circuit élémentaire supplémentaire (DET) est insensible à la température.

## Patentansprüche

1. Einrichtung mit einem funktionellen elektronischen Schaltkreis und einer Neutralisierungsvorrichtung zum Blockieren der Funktion des funktionellen elektronischen Schaltkreises, wenn die Versorgungsspannung unzureichend ist, um eine korrekte Funktion sicherzustellen,
wobei der funktionelle elektronische Schaltkreis mehrere potentielle kritische Pfade zwischen einem Versorgungsanschluß und einem Masseanschluß aufweist, wobei ein Pfad kritisch ist, wenn der Wert der Versorgungsspannung, der notwendig ist, um die korrekte Funktion seiner Komponente oder Gruppe von Komponenten sicherzustellen, ausreicht, um sicherzustellen, daß die Funktion der Einrichtung korrekt ist,
wobei die Neutralisierungsvorrichtung oberhalb einer Inhibitorvorrichtung (OR) zum Blockieren der Funktion des elektronischen Schaltkreises einen Steuerschaltkreis (CC) umfaßt, der die potentiellen kritischen Pfade des funktionellen elektronischen Schaltkreises in Form von elementaren Schaltkreisen (CE1, ... CEn) darstellt, wobei jeder zwischen den Versorgungsanschluß und den Masseanschluß geschaltet ist und ein elementares Signal (POR1, ... PORn) ausgibt, das mit seinem Zustand angibt, ob die Versorgungsspannung zum Sicherstellen der korrekten Funktion ausreichend ist, wobei die Inhibitorvorrichtung nur deaktiviert wird, wenn die Gesamtheit der elementaren Schaltkreise (CE1, ... CEn) Elementarsignale mit dem gleichen Zustand ausgeben, der anzeigt, daß die Versorgungsspannung ausreicht, um sicherzustellen, daß ihre Funktion korrekt ist.

2. Einrichtung nach Anspruch 1, dadurch gekennzeichnet, daß der Steuerschaltkreis (CC) der Neutralisierungsvorrichtung ein Logikgatter (OR) umfaßt, das über jeden der Eingänge die elementaren Signale (POR1, ... PORn) empfängt und ein Steuersignal (POR) an die Inhibitorvorrichtung ausgibt.

3. Einrichtung nach einem der Ansprüche 1 oder 2, dadurch gekennzeichnet, daß die potentiellen kritischen Pfade des elektronischen Schaltkreises durch die elementaren Schaltkreisen (CE1, ... CEn) mit Komponenten oder Gruppen von Komponenten (10, 20, 30 und 31) dargestellt werden, die nur kleine Widerstände aufweisen.

4. Einrichtung nach einem der vorangehenden Ansprüche, dadurch gekennzeichnet, daß einer der kritischen Pfade des elektronischen Schaltkreises einen ursprünglichen Transistor vom P-Typ (10) umfaßt.

5. Einrichtung nach einem der vorangehenden Ansprüche, dadurch gekennzeichnet, daß einer der kritischen Pfade des elektronischen Schaltkreises einen Hochspannungstransistor vom N-Typ (20) umfaßt.

6. Einrichtung nach einem der vorangehenden Ansprüche, dadurch gekennzeichnet, daß einer der kritischen Pfade des elektronischen Schaltkreises zwei Transistoren vom N-Typ (30, 31), die in Reihe geschaltet sind (31), umfaßt, von denen einer als Diode geschaltet ist.

7. Einrichtung nach einem der vorangehenden Ansprüche, dadurch gekennzeichnet, daß der Steuerschaltkreis der Neutralisierungsvorrichtung außerdem einen zusätzlichen elementaren Schaltkreis (DET) umfaßt, der ein elementares Signal (TPOR) ausgibt, das den Zustand bei einem festen Wert der Versorgungsspannung ändert, so daß er ein minimaler Schwellenwert der Versorgungsspannung ist, so daß sichergestellt ist, daß die Deaktivierung der Inhibitorvorrichtung (OR) erfolgt.

8. Einrichtung nach Anspruch 7, dadurch gekennzeichnet, daß der zusätzliche elementare Schaltkreis DET unabhängig von der Temperatur ist.

## Claims

1. Assembly comprising a functional electronic circuit and a neutralisation device intended to block the functioning of the said functional electronic circuit when the supply voltage is insufficient to ensure the correct functioning thereof,
the functional electronic circuit having a plurality of potential critical paths between a supply terminal and an earth terminal, a path being critical when the value of the supply voltage necessary for ensuring the correct functioning of its component or group of components is sufficient to ensure the correct functioning of the assembly,
the neutralisation device comprising, upstream of an inhibiting means (OR) for blocking the functioning of the electronic circuit, the control circuit (CC) reproducing the potential critical paths of the functional electronic circuit in the form of elementary circuits (CE1...CEn), each connected between the supply terminal and the earth terminal and delivering a elementary signal (POR1...PORn) indicating by its state whether the supply voltage is sufficient for ensuring its correct functioning, the inhibiting means being deactivated only when all the elementary circuits (CE1...CEn) deliver elementary signals with the same state indicating that the supply voltage is sufficient to ensure their correct functioning.

2. Assembly according to Claim 1, characterised in that the control circuit (CC) of the neutralisation device has a logic gate (OR) receiving, at each of its inputs, one of the elementary signals (POR1...PORn) and delivering a control signal (POR) to the inhibiting means.

3. Assembly according to one of Claims 1 or 2, characterised in that the potential critical paths of the electronic circuit are reproduced in the elementary circuits (CE1...CEn) with components or groups of components (10, 20, 30 and 31) which are weakly resistant.

4. Assembly according to one of the preceding claims, characterised in that one of the critical paths of the electronic circuit includes a p-type native transistor (10).

5. Assembly according to one of the preceding claims, characterised in that one of the critical paths of the electronic circuit includes an n-type high-voltage transistor (20).

6. Assembly according to one of the preceding claims, characterised in that one of the critical paths of the electronic circuit includes two n-type transistors (30, 31) connected in series (31), one of which is connected as a diode.

7. Assembly according to one of the preceding claims, characterised in that the control circuit of the utilisation device also includes a supplementary elementary circuit (DET) producing an elementary signal (TPOR) which changes state for a fixed value of the supply voltage, determined so that it is a minimum threshold value of the supply voltage able to ensure deactivation of the inhibiting means (OR).

8. Assembly according to Claim 7, characterised in that the supplementary elementary circuit (DET) is insensitive to temperature.
